# EUROPÄISCHE PATENTSCHRIFT

(11) **EP 3 270 666 B1**
(45) Veröffentlichungstag und Bekanntmachung des Hinweises auf die Patenterteilung: **20.11.2019**
(21) Anmeldenummer: 17180738.1
(22) Anmeldetag: 11.07.2017
(51) Int. Cl.: H05K 5/00

(54) **VORRICHTUNG ZUR AUFNAHME VON ELEKTRONISCHEN BAUEINHEITEN**
DEVICE FOR RECEIVING ELECTRONIC COMPONENTS
DISPOSITIF DE LOGEMENT D'UNITÉS DE CONSTRUCTION ÉLECTRONIQUES

(30) Priorität: 13.07.2016 DE 102016112837
(43) Veröffentlichungstag der Anmeldung: 17.01.2018
(73) Patentinhaber: INTERMAS-ELCOM GmbH, 64293 Darmstadt (DE)
(72) Erfinder: HITZEL, Florian, 63322 Rödermark-Urberach (DE); HÖRBE, Siegfried, 61273 Wehrheim (DE); KLOTZ, Burkhard, 64823 Groß-Umstadt (DE)
(74) Vertreter: Stoffregen, Hans-Herbert

(56) Entgegenhaltungen:
- US-A1- 2013 328 466

## Beschreibung

Die Erfindung bezieht sich auf eine Vorrichtung zur Aufnahme von elektronischen Baueinheiten, umfassend ein Gehäuse mit Boden-, Kopf-, Frontseiten-, Rückseiten- und Seitenwandungen sowie Positionierelemente, mittels derer die elektronischen Baueinheiten in dem Gehäuse fixierbar sind, die vorzugsweise entsprechend einem vorgegebenen Raster in dem Gehäuse angeordnet sind.

Entsprechende Vorrichtungen können Bauträger sein, die grundsätzlich aus einem offenen Gehäuse aus Metall bestehen, die zur Aufnahme von Leiterplatten oder Steckplatten und Baugruppen bestimmt sind. Die üblichen Baugruppenträger entsprechen der 19" Bauweise. Baugruppenträger enthalten üblicherweise Führungsschienen für den Halt der Baugruppen, einen Rückwandbus, der auch als Busplatine oder Backplane bezeichnet wird, zur Aufnahme der Steckkontakte und Stecker für die Verbindung zum Rückwandbus und Verbindung der Baugruppen untereinander.

Bei der Herstellung der Baugruppenträger muss darauf geachtet werden, dass geringe Toleranzen eingehalten werden, da andernfalls eine ordnungsgemäße Bestückung nicht möglich ist.

Da die Gehäuse offen sind, ist ein Einsatz in Bereichen hoher Feuchtigkeit nicht möglich.

Die DE 26 39 390 A1 bezieht sich auf einen Ständer zur parallelen Anordnung einer Anzahl von Schaltungsplatten. Hierzu ist ein Gehäuse vorgesehen, das aus geschlossenen Seitenwandungen sowie durch zueinander beabstandete Profilstangen gebildeten Boden- und Kopfwandungen besteht.

Die Profilstäbe weisen Nuten auf, in die hakenförmig ausgebildete Abschnitte von z. B. aus Kunststoff bestehenden Führungsformteilen einschiebbar sind.

Gegenstand der DE 298 01 997 U1 ist eine variable Kartenführungseinrichtung für Elektronikgehäuse.

Von Innenflächen der Wandungen des Gehäuses ragen schwalbenschwanzförmige Nocken ab, in die Kartenführungsadapter einschiebbar sind, um Elektronikkarten unterschiedlicher Abmessungen aufnehmen zu können.

Der DE 93 13 000 U1 ist ein Einschubprofil für Schrank- oder Gehäuse-Innenräume zu entnehmen. Zur Aufnahme von Platinen werden aus eloxiertem Aluminium bestehende Profilplatten genutzt, die endseitig Gabelschenkel aufweisen, um in Nuten des Gehäuses eingesetzt zu werden.

Aus der US 2013/0328466 A1 ist ein Gehäuse zur Aufnahme elektronischer Geräte bekannt, das aus Kopf-, Seiten- und Bodenwandungen besteht, die in Längsrichtung verlaufende Profilierungen zur Wärmeableitung aufweisen.

Die mit der vorliegenden Erfindung zu lösende Aufgabe kann darin gesehen werden, dass eine Weiterbildung der aus US 2013/0328466 A1 bekannten Vorrichtung gesucht wird, um ihre Leistungsfähigkeit zu verbessern. Diese Aufgabe wird durch eine Vorrichtung gemäß Anspruch 1 gelöst.

Ein Aspekt der vorliegenden Erfindung ist es, eine Vorrichtung der eingangs genannten Art so weiterzubilden, dass zur Herstellung Materialien eingesetzt werden können, die herstellungsbedingt Toleranzen aufweisen, die an und für sich einen Einsatz der Vorrichtung in der Funktion eines Bauträgers als nicht geeignet erscheinen lassen, ungeachtet dessen jedoch die Baueinheit in dem Gehäuse in einem Raster anordbar ist, das enge Toleranzen fordert, um den DIN-Normen zu genügen.

Nach einem weiteren Aspekt der Erfindung soll die Möglichkeit des Einsatzes in feuchter Umgebung eröffnet werden.

Zur Lösung zumindest eines Aspektes sieht die Erfindung im Wesentlichen vor, dass die Boden- und Kopfwandung Abschnitte eines Profils sind mit in Längsrichtung verlaufenden Profilierungen, dass in einigen der Profilierungen die Positionierelemente insbesondere in Form von Lochleisten oder Gewindeleisten lösbar eingesetzt sind, die aus einem von dem Profil abweichenden Material bestehen und mit geringerer Toleranz als das Profil hergestellt sind, und dass in den Positionierelementen Führungshalter oder Führungsschienen für die elektronischen Baueinheiten fixierbar sind.

Erfindungsgemäß besteht die Vorrichtung aus einem Materialmix derart, dass kostengünstige mechanisch stark belastbare und damit verwindungssteife Materialien für die Herstellung der Boden- und Kopfwandung benutzt werden, die über die Front- und Rückseitenwandungen sowie die senkrecht zu diesen verlaufenden Seitenwandungen miteinander verbunden werden. Es wird somit ein sehr stabiles Gehäuse zur Verfügung gestellt. Entsprechende insbesondere stranggepresste und aus Aluminium bestehende Profile weisen zwar in der Tiefe des Gehäuses die einzuhaltenden Toleranzen auf, um ein ordnungsgemäßes Positionieren der elektronischen Baueinheiten in dem Gehäuse sicherzustellen, jedoch nicht in der Breite des Gehäuses, insbesondere dann, wenn z. B. Teilungseinheiten bis 84 TE mit 1 TE = 5,08 mm realisiert werden sollen.

Um ungeachtet dessen in der Breite des Gehäuses die notwendigen Toleranzen zum ordnungsgemäßen Positionieren der elektronischen Baueinheiten zu gewährleisten, werden in Profilierungen des Profils die Positionierelemente eingesetzt, in denen Führungshalter oder Führungsschienen fixierbar sind, mit denen die elektronischen Baueinheiten bzw. diese aufnehmende Halterungen wie Führungshalter oder Steckverbinder verbunden werden. Insbesondere sind die Führungshalter oder -schienen in die Positionierelemente einsteckbar.

In Weiterbildung der Erfindung bzw. nach einem selbständigen Lösungsvorschlag zur Lösung eines weiteren Aspekts der Erfindung ist vorgesehen, dass das Gehäuse zumindest strahlwassergeschützt, insbesondere gegen zeitweiliges Untertauchen geschützt ausgebildet ist, und zwar gemäß der Schutzarten IP65, IP66 und IP67.

Erfindungsgemäß wird ein geschlossenes Gehäuse vorgeschlagen, das den zuvor erwähnten Schutzarten genügt und außerdem die erforderliche Verwindungssteifigkeit aufweist, gleichzeitig jedoch die Funktion eines Baugruppenträgers und den durch die Normen vorgegebenen Toleranzen genügt. Dabei ist insbesondere die Verwendung der Strangpressprofile und die in diesen vorhandenen Profilierungen zur Aufnahme von Positionierelementen zu erwähnen, die in der Breite des Gehäuses die erforderlichen Toleranzen gewährleisten.

In Weiterbildung der Erfindung ist vorgesehen, dass das Profil zumindest zwei, vorzugsweise zumindest drei erste Profilierungen aufweist, dass in die ersten Profilierungen erste Positionierelemente vorzugsweise in Form von ersten Lochleisten angeordnet sind, in die die Führungshalter- oder schienen für elektronische Baueinheiten wie Leiterplatten einsteckbar sind.

In Weiterbildung schlägt die Erfindung vor, dass das Profil zumindest eine zweite Profilierung, vorzugsweise drei zweite Profilierungen aufweist, dass in der zweiten Profilierung eine Gewindeleiste als zweites Positionierelement angeordnet ist, in das ein Schraubelement einschraubbar ist, mittels dessen eine elektronische Baueinheit wie ein Verdrahtungsträger wie Backplane, Busplatine oder Steckverbinder fixierbar ist. Dabei ist insbesondere vorgesehen, dass die elektronische Baueinheit wie Verdrahtungsträger wie Busplatine oder Steckverbinder nicht unmittelbar mit dem Schraubelement verbunden ist, sondern über ein Halteelement wie Haltewinkel, das seinerseits mit z. B. der Backplane, Busplatine oder dem Steckverbinder verbunden ist.

In weiterer Ausgestaltung der Erfindung ist vorgesehen, dass das Profil zumindest eine dritte Profilierung aufweist, die benachbart zu der zweiten Profilierung verläuft, dass die dritte Profilierung von gehäuseinnenseitig verlaufender innerer Fläche des Profils ausgeht und einen rechteckigen bzw. rechteckförmigen Querschnitt aufweist, innerhalb derer abschnittsweise ein Befestigungsmittel wie Haltewinkel verläuft, das einerseits mit dem Verdrahtungsträger wie Busplatine oder Steckverbinder und andererseits über das Schraubelement mit der Gewindeleiste verbunden ist.

Somit weist das Profil eine Profilierung auf, wobei in Bereiche dieser mit geringer Toleranz hergestellte Lochleisten bzw. Gewindeleisten einschiebbar sind, so dass über diese eine Positionierung der Leiterplatten bzw. Busplatine oder ein entsprechendes für die Funktion benötigtes elektronisches Bauteil in gewünschter Position fixierbar ist, um insbesondere Normen bzw. DIN-Vorschriften, insbesondere DIN EN ISO 60297-3-100, DIN EN ISO 60297-3-101 und/oder DIN EN ISO 60297-3-104, zu genügen.

Die ersten Profilierungen sind für die Positionierung von Führungshaltern- bzw. schienen und die zweiten und dritten Profilierungen zur Fixierung von Befestigungsmitteln wie Haltewinkeln bestimmt, über die wiederum Baugruppen wie Verdrahtungsträger, Backplanes, Busplatinen, Steckverbinder positioniert werden.

In Weiterbildung der Erfindung ist vorgesehen, dass von einer der Seitenbegrenzungen der eine im Schnitt rechteckige Nut bildenden vierten Profilierung eine Ausbuchtung ausgeht, in der sich abschnittsweise ein Befestigungselement, wie Schraube, für das Halteelement, wie den Haltewinkel, erstreckt. Dabei ist insbesondere vorgesehen, dass die Ausbuchtung außenseitig von einem senkrecht zur von dem Profil aufgespannten Ebene verlaufenden Profilabschnitt begrenzt ist, der seinerseits die zweite Profilierung bzw. deren parallel zu der Ebene verlaufenden Schenkel der im Schnitt ein reckwinkliges Kreuz bildenden zweiten Profilierung begrenzt.

Ferner sieht die Erfindung vor, dass von gehäuseaußenseitig verlaufender Fläche des Profils nach außen hin offene Aussparungen, wie Langlöcher, ausgehen, in die Befestigungselemente eingreifen, über die die Seitenwandungen mit den Profilen verbunden sind.

Hervorzuheben ist des Weiteren, dass die Wandungen gegeneinander über Dichtungen, insbesondere Flachdichtungen, abgedichtet sind, wobei insbesondere die Rück- und Frontseitenwandungen über eine umlaufende Dichtung gegenüber Boden- und Kopfwandung und boden- und kopfwandseitig verlaufenden Stirnrändern der Seitenwandungen und/oder diese über streifenförmige Dichtungen gegenüber den zugewandten Stirnrändern der Kopf- und Bodenwandungen abgedichtet sind.

Selbstverständlich kann eine Abdichtung auch über Rundschnüre erfolgen. Andere Maßnahmen, um eine Abdichtung zu erzielen, wie z. B. Verbinden durch Löten, ist gleichfalls möglich.

Bei Verwendung einer Flachdichtung ist insbesondere vorgesehen, dass diese von die Wandungen verbindenden Verbindungsmitteln wie Schrauben durchsetzt ist.

Als Flachdichtung ist insbesondere eine solche zu verwenden, die aus Silikon, insbesondere Fluorsilikon, besteht. Sofern gleichzeitig eine Abschirmung gegen elektromagnetische Strahlung erfolgen soll, ist insbesondere vorgesehen, dass die Dichtungen elektrisch leitend sind. So können die Dichtungen leitende Partikel zum Beispiel aus versilbertem Aluminium oder vernickeltem Graphit enthalten.

Das Gehäuse selbst ist bevorzugterweise vollumfänglich geschlossen, wobei zumindest eine abdichtende Kabeldurchführung vorhanden ist. Die Abdichtungen der Wandungen gegeneinander ermöglicht, dass die Vorrichtung der Schutzart IP65 oder sogar IP67 genügt. Dabei kann die Dichtung auch ein Material enthalten, das den Innenraum gegen elektromagnetische Strahlung abschirmt.

Bestehen die Profile bevorzugterweise aus abgelängten Strangpressprofilen aus Aluminium, so sollten die Positionierelemente aus verzinktem Stahl oder Edelstahl bestehen.

Die Positionierelemente sind insbesondere Lochleisten oder Gewindeleisten, die mit engen Toleranzen hergestellt sind. Somit weist das Gehäuse des Bauträgers über dessen Breite eine den DIN-Vorschriften entsprechende Positionier- bzw. Fixiermöglichkeit für die elektronischen Baueinheiten auf, gleichwenn die Kopf- bzw. Bodenwandung über die Breite des Gehäuses, also in Richtung parallel zu der Front- bzw. Rückseite, nicht die erforderliche Toleranz besitzen muss.

Eigenerfinderisch ist Gegenstand der Erfindung auch eine Vorrichtung zur Aufnahme von elektronischen Baueinheiten, umfassend ein Gehäuse mit Boden-, Kopf-, Frontseiten-, Rückseiten- und Seitenwandungen sowie Positionierelemente, mittels derer die elektronischen Baueinheiten in dem Gehäuse positionierbar sind, die vorzugsweise entsprechend einem vorgegebenen Raster in dem Gehäuse angeordnet sind, die sich dadurch auszeichnet, dass die Boden-, Kopf-, Frontseiten-, Rückseiten- und Seitenwandung ein vollumfänglich geschlossenes Gehäuse mit abdichtender Kabeldurchführung bilden und gegeneinander über Dichtungen abgedichtet sind, durch die das Innere des Gehäuses zumindest spritzwassergeschützt ist.
Dabei kann die Vorrichtung durch Ausgestaltungen entsprechend der zuvor oder in den Ausführungsbeispielen beschriebenen Merkmale weitergebildet sein.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: einen Baugruppenträger in auseinandergezogener Darstellung,
- Fig. 2: einen Schnitt durch ein Profil,
- Fig. 3: das Profil gemäß Fig. 2 mit Führungshalter und Busplatine,
- Fig. 4: einen Schnitt durch den Baugruppenträger ohne Frontwandung und Leiterplatten, jedoch mit Steckverbinder,
- Fig. 5: in vergrößerter Darstellung einen Abschnitt eines Strangpressprofils,
- Fig. 6: einen weiteren Abschnitt des Strangpressprofils mit Loch- und Gewindeleiste und
- Fig. 7: einen weiteren Abschnitt des Strangpressprofils.

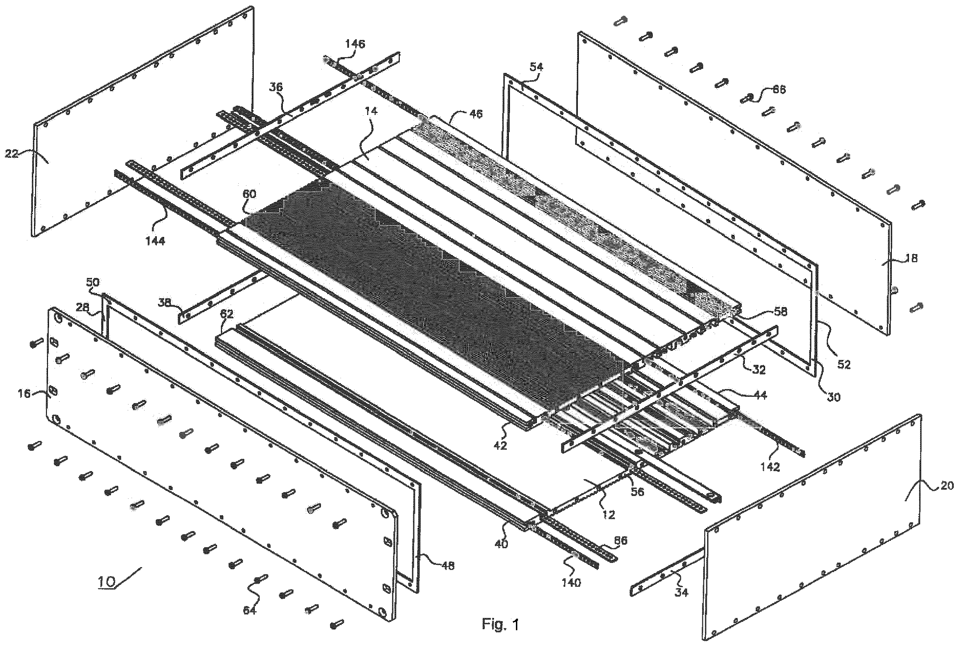

Die Figuren, in denen grundsätzlich gleiche Elemente mit gleichen Bezugszeichen gekennzeichnet sind, zeigen Ausschnitte eines Baugruppenträgers 10. In Fig. 1 ist der Baugruppenträger 10 auseinandergezogen.

Der erfindungsgemäße Baugruppenträger 10 besteht aus einem vollumfänglich geschlossenen Gehäuse und weist eine Bodenwandung 12, eine Kopfwandung 14, eine Frontseitenwandung 16, eine Rückseitenwandung 18 sowie Seitenwandungen 20 und 22 auf.

Die Wandungen 12, 14, 16, 18, 20, 22 sind gegeneinander derart abgedichtet, dass sich zumindest eine Schutzart IP65 ergibt, d.h. dass das Gehäuseinnere zumindest gegen Strahlwasser geschützt ist. Dabei kann die Abdichtung derart ausgebildet sein, dass das Innere des Baugruppenträgers 10 gegen elektromagnetische Strahlung abgeschirmt ist.

In dem Baugruppenträger 10 werden in gewohnter Weise elektronische Baueinheiten positioniert, zu denen parallel zu den Seitenwandungen 20, 22 ausgerichtete Leiterplatten und quer zu diesen und entlang der Rückseitenwandung 18 verlaufende, auch als Backplane zu bezeichnende Busplatine 24 oder Steckverbinder 26 oder sonstige elektronische Baueinheiten gehören, wie diese bei Baugruppenträgern Verwendung finden. Insoweit wird jedoch auf hinlänglich bekannte Ausführungsformen verwiesen.

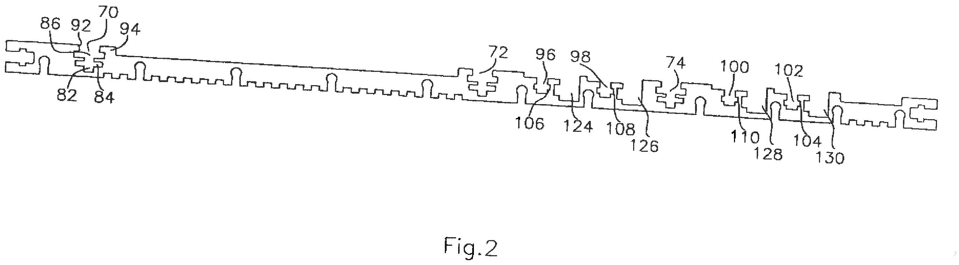

Bevorzugterweise sollte jedoch die Möglichkeit bestehen, dass vier Befestigungsebenen zur Backplane- oder Steckverbindermontage zur Verfügung stehen, wie sich dies auch aus der Fig. 2 ergibt.

Wesentliches Merkmal der Erfindung ist, dass die Boden- und die Kopfwandung 12, 14 jeweils Abschnitte eines Profils, insbesondere Strangpressprofils, vorzugsweise aus Aluminium sind, die ihrerseits nachstehend zu erläuternde Profilierungen aufweisen, in die Positionierelemente eingebracht werden, die somit parallel zu der Frontseiten- und Rückseitenwandung 16, 18 verlaufen und in der Breite des Gehäuses sicherstellen, dass die für Baugruppenträger einzuhaltende Rasterabstände zum Positionieren der elektronischen Baueinheiten sichergestellt sind.

Die Profile sind in Bezug auf deren Längsrichtung, also in Richtung parallel zur Front- und Rückseitenwandung 16, 18 nicht in einem Umfang mit Toleranzen herstellbar, dass Positionierelemente für die einzusetzenden elektronischen Baueinheiten unmittelbar ausgebildet werden können, die die einzuhaltenden Toleranzen aufweisen. Demgegenüber ist in Richtung der Tiefe des Gehäuses, also parallel zu den Seitenwandungen 20, 22 die erforderliche Toleranz einhaltbar. Somit können die die nachstehend beschriebenen Positioniermittel aufnehmenden Profilierungen derart zueinander beabstandet werden, dass die erforderlichen einzuhaltenden Abstände zum Positionieren der die elektronischen Baueinheiten fixierenden Einbauten gewahrt sind.

Wie sich aus der Fig. 1 ergibt, sind die Wandungen 12, 14, 16, 18, 20, 22 über Dichtungen 28, 30, 32, 34, 36, 38 gegeneinander abgedichtet. Dabei handelt es sich im Ausführungsbeispiel um Flachdichtungen, ohne dass hierdurch die erfindungsgemäße Lehre eingeschränkt wird.

Insbesondere handelt es sich um Flachdichtungen, die aus Silikon bzw. Fluorsilikon bestehen. Sofern eine elektromagnetische Abschirmung gewünscht wird, sind die Dichtungen elektrisch leitend. Hierzu können vorzugsweise die Flachdichtungen, die erwähntermaßen aus Silikon bzw. Fluorsilikon bestehen können, leitende Partikel enthalten, insbesondere aus versilbertem Aluminium oder vernickeltem Graphit.

Gleichfalls rein beispielhaft, jedoch bevorzugt ist vorgesehen, dass über die umlaufend ausgebildeten Dichtungen 28, 30 eine Abdichtung zwischen der Front- und Rückseitenwandung 16, 18 und den Stirnrändern 40, 42, 44, 46 der Boden- und Kopfwandung 12, 14 erfolgt. Des Weiteren dichten die kurzen, also senkrecht zu der Boden- und Kopfseite 12, 14 verlaufenden Schenkel 48, 50, 52, 54 der Dichtungen 28, 30 die nicht näher gekennzeichneten und zwischen der Kopf- und der Bodenwandung 12, 14 verlaufenden Stirnränder der Seitenwandung 20, 22 gegenüber der Front- und Rückseitenwandung 16, 18 ab. Die verbleibenden Stirnränder 56, 58, 60, 62 der Boden- und Kopfwandung 12, 14 sind gegenüber den Seitenwandungen 20, 22 über die streifenförmigen Dichtungen 32, 34, 36, 38 abgedichtet.

Die Dichtungen 28, 30, 32, 34, 36, 38 stellen sicher, dass der Baugruppenträger 10 der Schutzart IP65, IP66 oder sogar IP67 entspricht.

Aus der zeichnerischen Darstellung ergibt sich des Weiteren, dass die die Wandungen 12, 14, 16, 18, 20, 22 verbindenden Schrauben, von denen einige mit den Bezugszeichen 64, 66 gekennzeichnet sind, die Dichtungen 28, 30, 32, 34, 36, 38 durchsetzen.

Bei den Dichtungen 28, 30, 32, 34, 36, 38 handelt es sich erwähntermaßen insbesondere um Flachdichtungen aus Silikon bzw. Fluorsilikon. Dabei können die Dichtungen 28, 30, 32, 34, 36, 38 auch aus einem Material bestehen oder ein solches enthalten, das eine elektromagnetische Strahlenabschirmung bietet. Hierzu können die Dichtungen 28, 30, 32, 34, 36, 38 leitende Partikel wie aus versilbertem Aluminium oder vernickeltem Graphit bestehende Partikel enthalten.

Die Front- und Rückseitenwandungen 16, 18 sowie die Seitenwandungen 20, 22 können aus aus Aluminium bestehenden Platten bestehen. Nicht dargestellt ist in der Zeichnung, dass insbesondere die Rückseitenwandung 18 eine abdichtende Öffnung aufweist, die von einem Kabel durchsetzt sein kann.

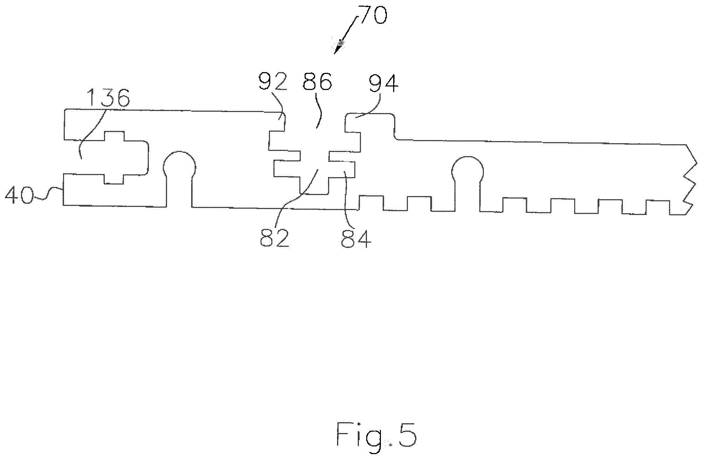

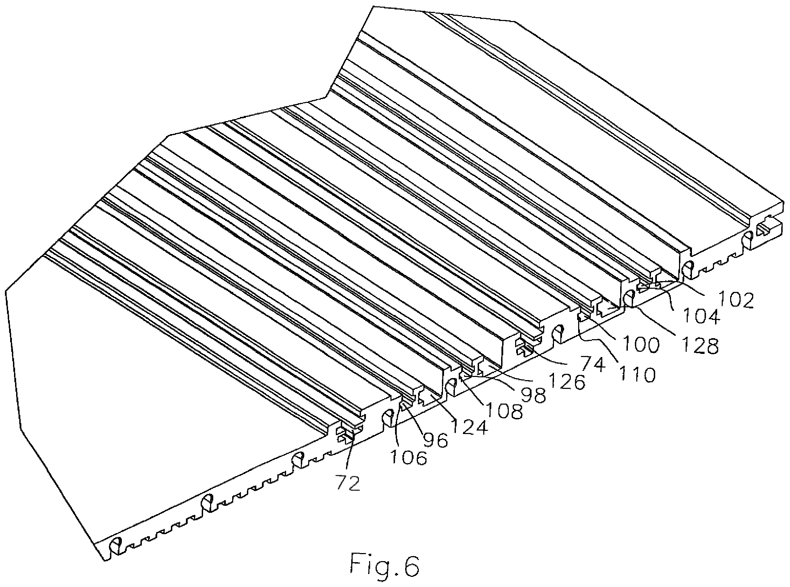

Aus den Darstellungen der Fig. 2 bis 7 ergibt sich die Struktur der die Boden- und Kopfwandung 12, 14 bildenden Profile. Diese sollen anhand der Fig. 2 näher erläutert werden. Den Fig. 5 bis 7 sind vergrößerte Darstellungen von Abschnitten der Profile zu entnehmen, aus denen sich die Geometrie der Profilierungen in den Profilen selbsterklärend ergeben. Insoweit stellen die Detaildarstellungen ein besonderes Offenbarungsmittel dar.

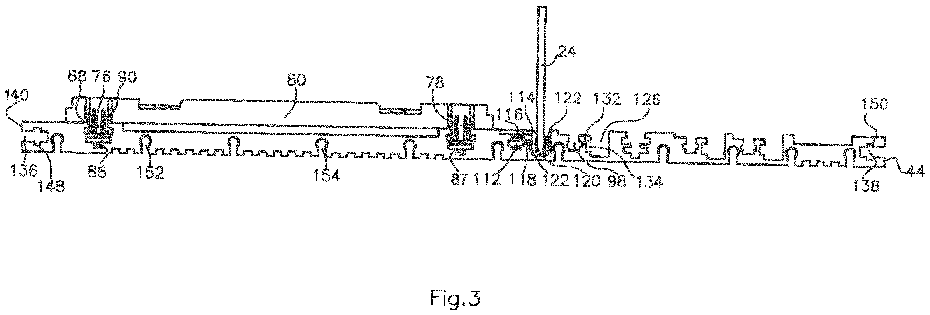

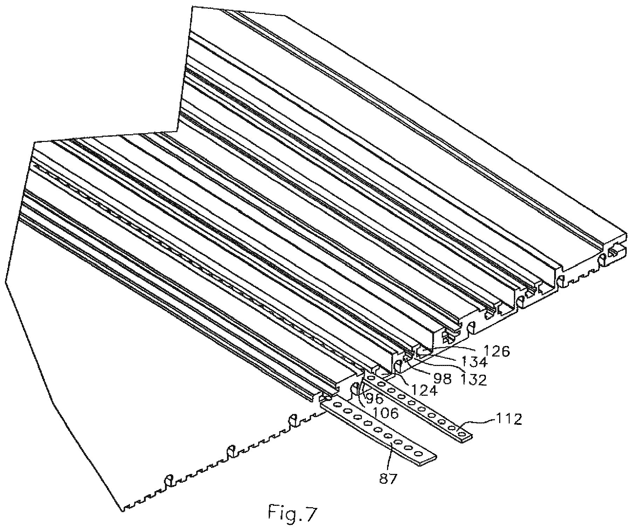

Zur Innenseite des Gehäuses des Baugruppenträgers 10 offen sind erste nutartige Profilierungen 70, 72, 74 vorgesehen, in die entsprechend der Fig. 3 Abschnitte 76, 78 eines Führungshalters 80 einrastbar sind. Die ersten Profilierungen 70, 72, 74 weisen einen im Schnitt ein rechtwinkliges Kreuz bildenden Abschnitt 82 auf, in dessen parallel zu der von dem Profil aufgespannten Ebene verlaufenden Schenkel 84 eine Lochleiste 86, 87 einschiebbar ist, die den Fig. 3, 7 zu entnehmen ist. Die Lochleisten 86 dienen zur eindeutigen Positionierung des Führungshalters 80.

Die insbesondere aus Stahl, insbesondere verzinktem Stahl oder Edelstahl bestehende Lochleiste 86 wird in den Schenkel 84 hineingeschoben, wobei der Lochabstand in einem Raster entsprechend den Teilungseinheiten TE mit 1 TE = 5,08 mm entspricht, wie dies durch die DIN EN ISO 60297 vorgegeben ist. Selbstverständlich kann auch ein anderes Lochraster nach einer anderen Norm oder Vorgaben in der Lochleiste 86 vorhanden sein.

Insbesondere sollte die Länge der Lochleiste ein Breitenraster von 84 TE ermöglichen.

Wie sich insbesondere aus den Fig. 3, 5 ergibt, befindet sich oberhalb der offenen im Schnitt ein rechtwinkliges Kreuz bildenden Profilierung 82 eine weitere im Schnitt ein T bildende Profilierung 86, die zum Inneren des Gehäuses offen ist. Hierdurch ergibt sich die Möglichkeit, dass Rastvorsprünge 88, 90 des Führungshalters 80 die entsprechenden die Profilierung 86 begrenzenden Schenkel 92, 94 hintergreifen können und somit verrasten. Ein zwischen diesen verlaufender Steg erstreckt sich in dem senkrecht zu der von dem Profil aufgespannten Ebene verlaufenden Schenkel der Profilierung 82, um in ein Loch der Lochleiste 86 einzugreifen.

Der Abstand der ersten Profilierung 70, 72, 74 ist dabei derart gewählt, dass genormte Führungshalter unterschiedlicher Länge einrastbar sind, um Platinen unterschiedlicher Längen aufzunehmen. Insbesondere sollen Führungshalter 80 oder Führungsschienen der Längen 160 mm oder 220 mm eingebaut werden können.

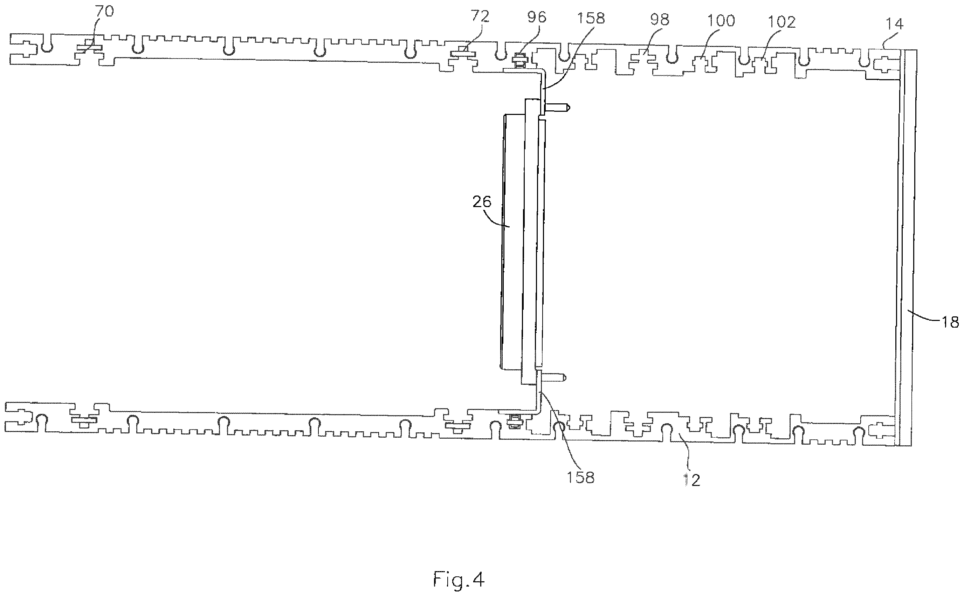

Neben den ersten Profilierungen weisen die Profile der Boden- und Kopfwandungen 12, 14, die symmetrisch bzw. spiegelsymmetrisch zueinander angeordnet sind - wie dies aus der Fig. 4 klar ersichtlich ist -, zweite Profilierungen auf, und zwar im Ausführungsbeispiel die Profilierungen 96, 98, 100, 102. Diese sind im genormten Abstand zur Frontseite des Gehäuses angeordnet, damit sich gleichfalls der Norm entsprechende Positionen für die Backplanes 24 ergeben, wie durch die Zeichnung verdeutlicht wird.

Die zweiten Profilierungen 96, 98, 100, 102 weisen gleichfalls im Schnitt eine rechtwinklige Kreuzgeometrie auf und sind zum Inneren des Gehäuses offen. Dabei wird in dem parallel zu der von dem Profil und somit der Boden- bzw. Kopfwandung 12, 14 aufgespannten Ebene verlaufenden Schenkel 104, 106, 108, 110 eine Gewindeleiste 112 hineingeschoben, die mit einer Backplane verbunden werden soll. Im Ausführungsbeispiel wäre dies die Profilierung 96, die unmittelbar benachbart zum Führungshalter 80 verläuft. Bohrungen mit Innengewinde sind entsprechend der vorgegebenen Norm in der Gewindeleiste 112 ausgebildet.

Die Backplane 24 wird über einen Haltewinkel 114, der aus Aluminium, insbesondere chromartiertem Aluminium bestehen kann, und eine Schraube 116 in einer gewünschten Bohrung mit Innengewinde der Gewindeleiste 112 befestigt.

Den zweiten Profilierungen 106, 108, 110, 112 sind benachbart dritte Profilierungen 124, 126, 128, 130 zugeordnet, die im Schnitt eine Rechteckgeometrie aufweisen und zum Gehäuseinneren offen sind. In die dritten Profilierungen 124, 126, 128, 130 ragen bodenseitig verlaufende Abschnitte sowohl der Backplane 24 als auch des Haltewinkels 114 hinein, wie sich aus der zeichnerischen Darstellung der Fig. 3 ergibt.

Dabei stützt sich der entlang der Backplane 24 verlaufende und in der zeichnerischen Darstellung vertikal verlaufende Schenkel 120 des Haltewinkels 114 an einem Abschnitt an der Seitenwandung der dritten Profilierung 124, 126, 128, 130 ab, die seitlich die zweite Profilierung 96, 98, 100, 102 begrenzt. Insoweit sind die zeichnerischen Darstellungen selbsterklärend.

Ferner erkennt man, dass in den zwischen der zweiten und der dritten Profilierung 96, 124, 98, 126, 100, 128, 102, 130 verlaufenden Wandungen, von denen eine in Fig. 3 mit dem Bezugszeichen 132 gekennzeichnet ist, ein zurückversetzter Abschnitt, also eine Ausbuchtung 134 verläuft, die einen Abschnitt der den Haltewinkel 114 mit der Backplane 24 verbindende Schraube 122 aufnimmt.

Durch die Verwendung des Haltewinkels 114 erfolgt eine sichere Befestigung der Backplane 24 mit dem Profil, gleichwenn in diesem Bereich das Profil relativ dünn ausgebildet ist, wie sich aus der zeichnerischen Darstellung ergibt.

Die zweiten und dritten Profilierungen 96, 98, 100, 102, 124, 126, 128, 130 sind derart zueinander angeordnet, dass eine DIN-konforme gerastete Positionierung von Baugruppen wie Verdrahtungsträger, Backplanes oder Steckverbinder erfolgt.

Die Boden- und Kopfwandungen 12, 14, also die Profile weisen des Weiteren vierte Profilierungen 136, 138 auf, die von den Stirnrandseiten 40, 42, 44, 46 ausgehen, in die Gewindeleisten 140, 142, 144, 146 einschiebbar sind, in die Schrauben eingedreht werden, über die die Frontseiten- und Rückseitenwandung 16, 18 mit der Boden- und Kopfwandung 12, 14 verbunden werden. Die entsprechenden vierten nutartigen Profilierungen 136, 138 weisen gleichfalls eine rechtwinklige Kreuzgeometrie auf, wobei in den senkrecht zu der von dem Profil aufgespannten Ebene verlaufenden Schenkel 148, 150 die Gewindeleiste 140, 142, 144,146 eingeschoben wird.

Um die Seitenwandungen 20, 22 mit den Profilen, also der Boden- und Kopfwandung 12, 14 zu verbinden, gehen von den Außenseiten der Profile nach außen hin offene Aussparungen wie Langlöcher aus, von denen einige beispielhaft mit den Bezugszeichen 152, 154 gekennzeichnet sind. Die Langlöcher 152, 154 weisen entsprechend der zeichnerischen Darstellung innenseitig Erweiterungen auf, in die die Schrauben eingedreht werden.

Wie bei Baugruppenträgern üblich, kann anstelle einer Backplane 24 auch senkrecht zu den von Führungshaltern 80 aufgenommenen Platinen ein Steckverbinder 26 vorgesehen sein. Dieser wird gleichfalls über Haltewinkel 156, 158 mit den in den zweiten Profilierungen 96, 98, verlaufenden Gewindeleisten verbunden, wie dies zuvor hinsichtlich der Backplane 24 erläutert worden ist. Insoweit wird auf die diesbezüglichen Ausführungen verwiesen.

Insbesondere aus der Fig. 4 wird auch ersichtlich, dass die die Boden- und Kopfwandung 12, 14 bildenden Profile spiegelsymmetrisch zueinander angeordnet sind. Somit sind die gleichen Profilierungen in gleicher Position in der Kopfwandung 14 wie in der Bodenwandung 12 vorhanden, so dass auf die zuvor erfolgten Erläuterungen verwiesen wird. Daher sind auch in den Profilen der Kopfwandung 14 die gleichen Bezugszeichen hinsichtlich der Profilierung wie in Bezug auf die Bodenwandung 12 verwendet worden.

Anzumerken ist noch, dass der Bauträger gewünschte Höheneinheiten aufweisen kann, wobei eine Höheneinheit 44,45 mm entspricht. Die Tiefe des Baugruppenträgers kann entsprechend der Platinenmaßen ausgebildet sein.

## Patentansprüche

1. Vorrichtung (10) zur Aufnahme von elektronischen Baueinheiten (24, 26), umfassend ein Gehäuse mit Boden-, Kopf-, Frontseiten-, Rückseiten- und Seitenwandungen (12, 14, 16, 18, 20, 22) sowie Positionierelemente (86, 112, 140, 142, 144, 146), mittels derer die elektronischen Baueinheiten in dem Gehäuse positionierbar sind, die vorzugsweise entsprechend einem vorgegebenen Raster in dem Gehäuse angeordnet sind, wobei
die Boden- und Kopfwandung (12, 14) Abschnitte eines Profils mit in Längsrichtung verlaufender Profilierung sind,
**dadurch gekennzeichnet dass** in einigen der Profilierungen die Positionierelemente (86, 112, 140, 142, 144, 146) lösbar eingesetzt sind, die aus einem von dem Profil abweichenden Material bestehen und die mit geringerer Toleranz als das Profil hergestellt sind, dass in den Positionierelementen Führungshalter (80) oder Führungsschienen für die elektronischen Baueinheiten (24, 26) fixierbar sind,
dass das Profil zumindest eine zweite Profilierung, vorzugsweise mehr als zwei zweite Profilierungen (96, 98, 100, 102), aufweist, und dass in der zweiten Profilierung eine Gewindeleiste (112) als zweites Positionierelement angeordnet ist, in das ein Schraubelement (116) einschraubbar ist, mittels dessen eine elektronische Baueinheit wie ein Verdrahtungsträger wie Busplatine (24) oder Steckverbinder (26) fixierbar ist.

2. Vorrichtung nach Anspruch 1,
**dadurch gekennzeichnet,**
**dass** das Gehäuse zumindest strahlwassergeschützt (IP 65), vorzugsweise starkes Strahlwasser (IP 66), insbesondere gegen zeitweiliges Untertauchen (IP 67) geschützt ausgebildet ist.

3. Vorrichtung nach Anspruch 1 oder 2,
**dadurch gekennzeichnet,**
**dass** das Gehäuse mit Ausnahme von abdichtender Kabeldurchführung vollflächig geschlossen ist.

4. Vorrichtung nach zumindest einem der vorhergehenden Ansprüche,
**dadurch gekennzeichnet,**
**dass** das Profil ein Strangpressprofil ist und insbesondere aus Aluminium besteht.

5. Vorrichtung nach zumindest einem der vorhergehenden Ansprüche,
**dadurch gekennzeichnet,**
**dass** das Profil zumindest zwei, vorzugsweise drei, erste Profilierungen (70, 72, 74) aufweist und dass in den ersten Profilierungen erste Positionierelemente (86, 87) in Form von ersten Lochleisten angeordnet sind, in denen die Führungshalter (80) für elektronische Baueinheiten wie Leiterplatten fixierbar sind, insbesondere in diese einsteckbar sind.

6. Vorrichtung nach zumindest einem der vorhergehenden Ansprüche,
**dadurch gekennzeichnet,**
**dass** das Profil zumindest eine dritte Profilierung (124, 126, 128, 130) aufweist, die benachbart zu der zweiten Profilierung (96, 98, 100, 102) verläuft

7. Vorrichtung nach zumindest einem der vorhergehenden Ansprüche,
**dadurch gekennzeichnet,**
**dass** die dritte Profilierung (124, 126, 128, 130) von gehäuseinnenseitig verlaufender Innenfläche des Profils ausgeht und einen rechteckigen bzw. rechteckförmigen Querschnitt aufweist, und dass innerhalb der dritten Profilierung abschnittsweise ein Befestigungsmittel, wie Haltewinkel (114), verläuft, das einerseits mit der elektronischen Baueinheit, wie dem Verdrahtungsträger wie Busplatine (24) oder Steckverbinder, und andererseits über ein Schraubelement (116) mit der Gewindeleiste (112) verbunden ist.

8. Vorrichtung nach zumindest einem der vorhergehenden Ansprüche,
**dadurch gekennzeichnet,**
**dass** das Profil in seinen Längsrändern und von deren Stirnflächen ausgehend vierte Profilierungen (136, 138) aufweist, in denen Gewindeleisten (140, 142, 144, 146) als vierte Positioniermittel zur Aufnahme von Schraubelementen eingeschoben sind, über die die Front- bzw. Rückseitenwandung (16, 18) mit der Boden- bzw. Kopfwandung (12, 14) verbunden sind.

9. Vorrichtung nach zumindest Anspruch 6,
**dadurch gekennzeichnet,**
**dass** von einer Seitenfläche der dritten Profilierung (124, 126, 128, 130) eine Ausbuchtung (134) ausgeht, in der sich abschnittsweise das den Haltewinkel (114) mit der elektronischen Baueinheit, wie dem Verdrahtungsträger wie Busplatine (24) oder Steckverbinder (26), verbindende Schraubelement (122) erstreckt.

10. Vorrichtung nach zumindest Anspruch 9,
**dadurch gekennzeichnet,**
**dass** die Ausbuchtung (134) von einem senkrecht zur von dem Profil aufgespannten Ebene verlaufenden Profilabschnitt begrenzt ist, der seinerseits die zweite Profilierung (96, 98, 100, 102) bzw. deren parallel zu der Ebene verlaufenden Schenkel der im Schnitt das rechtwinklige Kreuz bildenden zweiten Profilierung begrenzt.

11. Vorrichtung nach zumindest einem der vorhergehenden Ansprüche,
**dadurch gekennzeichnet,**
**dass** von gehäuseaußenseitig verlaufender Fläche des die Boden- und Kopfwandung (12, 14) bildenden Profils nach außen in offene Aussparungen, wie Langlöcher (152, 154), ausgehen, in die Befestigungselemente eingreifen, über die die Seitenwandungen (20, 22) mit der Kopf- bzw. Bodenwandung (12, 14) verbunden sind.

12. Vorrichtung nach zumindest einem der vorhergehenden Ansprüche,
**dadurch gekennzeichnet,**
**dass** die Positionierelemente (86, 112, 114, 142, 144, 146) als Lochleiste oder Gewindeleiste ausgebildet sind und vorzugsweise aus Stahl, insbesondere verzinktem Stahl oder Edelstahl, bestehen.
**dass** die Dichtungen Flachdichtungen (28, 30,

13. Vorrichtung nach zumindest einem der vorhergehenden Ansprüche,
**dadurch gekennzeichnet,**
**dass** die Boden-, Kopf-, Frontseiten-, Rückseiten- und Seitenwandung (12, 14, 16, 18, 20, 22) ein vollumfänglich geschlossenes Gehäuse mit abdichtender Kabeldurchführung bilden und gegeneinander über Dichtungen (28, 30, 32, 34, 36, 38) abgedichtet sind, durch die das Innere des Gehäuses zumindest spritzwassergeschützt ist.

14. Vorrichtung nach zumindest Anspruch 13,
**dadurch gekennzeichnet,**
**dass** die Dichtungen Flachdichtungen (28, 30, 32, 34, 36, 38) sind, die insbesondere aus Silikon, vorzugsweise Fluorsilikon, bestehen und gegebenenfalls elektrisch leitende Partikel aus zum Beispiel versilbertem Aluminium oder verzinktem Graphit enthalten.

## Claims

1. Device (10) for receiving electronic components (24, 26) comprising a housing with bottom, top, front, rear and side walls (12, 14, 16, 18, 20, 22) and positioning elements (86, 112, 140, 142, 144, 146) by means of which the electronic components are positionable inside the housing and arranged inside the housing preferably in accordance with a predetermined grid, the bottom and top walls (12, 14) being portions of a section with profile in the longitudinal direction,
wherein
in some of the profiles the positioning elements (86, 112, 140, 142, 144, 146) are detachably inserted which consist of a material differing from that of the section and are manufactured to a lower tolerance than the section, guide holders (80) or guide rails for the electronic components (24, 26) are fixable in the positioning elements, the section has at least one second profile and preferably more than two second profiles (96, 98, 100, 102), and in the second profile a threaded strip (112) is arranged as second positioning element into which is screwable a screw element (116) by means of which an electronic component such as a circuit board, for example a backplane (24) or plug connector (26), is fixable.

2. Device according to claim 1,
wherein
the housing is designed at least water-jet-protected (IP 65), preferably protected against powerful water jets (IP 66) and in particular against temporary immersion (IP 67).

3. Device according to claim 1 or 2,
wherein
the housing is closed over its full surface with the exception of a sealing cable leadthrough.

4. Device according to at least one of the preceding claims,
wherein
the section is an extruded section and consists in particular of aluminium.

5. Device according to at least one of the preceding claims,
wherein
the section has at least two and preferably three first profiles (70, 72, 74), and in the first profiles first positioning elements (86, 87) in the form of first perforated strips are arranged inside which the guide holders (80) for electronic components such as printed circuit boards are fixable, in particular insertable into these.

6. Device according to at least one of the preceding claims,
wherein
the section has at least one third profile (124, 126, 128, 130) extending adjacent to the second profile (96, 98, 100, 102).

7. Device according to at least one of the preceding claims,
wherein
the third profile (124, 126, 128, 130) extends from an inner surface of the section on the inside of the housing and has a rectangular or rectangular-shaped cross-section, and inside the third profile a fastening means such as a holding bracket (114) extends in some portions and is connected on the one side to the electronic component, such as the circuit board, for example a backplane (24) or plug connector, and on the other side to the threaded strip (112) via a screw element (116).

8. Device according to at least one of the preceding claims,
wherein
the section has in its longitudinal edges and extending from their end faces fourth profiles (136, 138) into which are inserted threaded strips (140, 142, 144, 146) as fourth positioning means for receiving screw elements by which the front and rear walls (16, 18) are connected to the bottom and top walls (12, 14).

9. Device according to at least claim 6,
wherein
from a side surface of the third profile (124, 126, 128, 130) extends a recess (134) in which extends in some portions the screw element (122) connecting the holding bracket (114) to the electronic component, such as the circuit board, for example a backplane (24) or plug connector (26).

10. Device according to at least claim 9,
wherein
the recess (134) is limited by a section portion vertical to the plane generated by the section and which in turn limits the second profile (96, 98, 100, 102) or its side, parallel to the plane, of the second profile forming the rectangular cross seen in section.

11. Device according to at least one of the preceding claims,
wherein
outwardly open cutouts such as slots (152, 154) extend from the surface, on the outside of the housing, of the section forming the bottom and top walls (12, 14), into which cutouts engage fastening elements by which the side walls (20, 22) are connected to the top and bottom walls (12, 14).

12. Device according to at least one of the preceding claims,
wherein
the positioning elements (86, 112, 114, 142, 144, 146) are designed as perforated strips or threaded strips and consist preferably of steel, in particular galvanized steel or special steel.

13. Device according to at least one of the preceding claims,
wherein
the bottom, top, front, rear and side walls (12, 14, 16, 18, 20, 22) form a housing closed over its full surface with a sealing cable leadthrough and are sealed off from one another by seals (28, 30, 32, 34, 36, 38) by which the interior of the housing is at least splash-water-protected.

14. Device according to at least claim 13,
wherein
the seals are gaskets (28, 30, 32, 34, 36, 38), which consist in particular of silicone, preferably fluorosilicone, and possibly contain electrically conducting particles of for example silver-plated aluminium or galvanized graphite.

## Revendications

1. Dispositif (10) de logement d'unités de construction électroniques (24, 26), comprenant un boîtier avec parois inférieure, supérieure, avant, arrière et latérales (12, 14, 16, 18, 20, 22) ainsi que des éléments de positionnement (86, 112, 140, 142, 144, 146) au moyen desquels les unités de construction électroniques sont positionnables dans le boîtier, lesquels éléments de positionnement sont disposés dans le boîtier de préférence selon une trame définie, sachant que la paroi inférieure et la paroi supérieure (12, 14) sont des sections d'un profil avec profilage s'étendant dans le sens longitudinal,
**caractérisé en ce**
**que** dans certains des profilages sont insérés les éléments de positionnement (86, 112, 140, 142, 144. 146) de manière détachable qui sont constitués d'un matériau différant de celui du profil et qui sont fabriqués avec une plus faible tolérance que le profil, que des supports de guidage (80) ou rails de guidage pour les unités de construction électroniques (24, 26) sont fixables dans les éléments de positionnement,
**que** le profil présente au moins un deuxième profilage, de préférence plus de deux deuxièmes profilages (96, 98, 100, 102), et qu'est disposée, dans le deuxième profilage, une barre filetée (112) servant de second élément de positionnement dans lequel est vissable un élément à vis (116) au moyen duquel une unité de construction électronique telle qu'un support de câblage comme une carte de bus (24) ou un connecteur enfichable (26) est fixable.

2. Dispositif selon la revendication 1,
**caractérisé en ce**
**que** le boîtier est conçu au moins protégé contre les jets d'eaux (IP 65), de préférence protégé contre les forts jets d'eau (IP 66), en particulier contre l'immersion temporaire (IP 67).

3. Dispositif selon la revendication 1 ou 2,
**caractérisé en ce**
**que** le boîtier est entièrement fermé à l'exception de la traversée de câble étanche.

4. Dispositif selon au moins une des revendications précédentes,
**caractérisé en ce**
**que** le profil est un profilé extrudé et est notamment constitué d'aluminium.

5. Dispositif selon au moins une des revendications précédentes,
**caractérisé en ce**
**que** le profil présente au moins deux, de préférence trois premiers profilages (70, 72, 74) et que dans les premiers profilages sont disposés des premiers éléments de positionnement (86, 87) en forme de premières barres perforées dans lesquelles les supports de guidage (80) pour les unités de construction électroniques, telles que des cartes à circuit imprimé, sont fixables, notamment sont enfichables.

6. Dispositif selon au moins une des revendications précédentes,
**caractérisé en ce**
**que** le profil présente au moins un troisième profilage (124, 126, 128, 130) qui s'étend au voisinage du deuxième profilage (96, 98, 100,102).

7. Dispositif selon au moins une des revendications précédentes,
**caractérisé en ce**
**que** le troisième profilage (124, 126, 128, 130) part de la surface intérieure du profil, s'étendant à l'intérieur du boîtier et présente une coupe transversale rectangulaire ou de forme rectangulaire, et qu'à l'intérieur du troisième profilage s'étend partiellement un moyen de fixation, tel qu'une équerre-support (114), qui est relié, d'une part, à l'unité de construction électronique telle que support de câblage comme une carte de bus (24) ou un connecteur enfichable, et d'autre part, à la barre filetée (112) par le biais d'un élément à vis (116).

8. Dispositif selon au moins une des revendications précédentes,
**caractérisé en ce**
**que** le profil présente des quatrièmes profilages (136, 138) dans ses bords longitudinaux et partant de leurs faces avant, dans lesquels sont insérées des barres filetées (140, 142, 144, 146) servant de quatrième moyen de positionnement pour loger des éléments à vis par le biais desquels les parois frontale ou arrière (16, 18) sont reliées à la paroi inférieure ou supérieure (12, 14).

9. Dispositif selon au moins la revendication 6,
**caractérisé en ce**
**que** part d'une face latérale du troisième profilage (124, 126, 128, 130) un retrait (134) dans lequel s'étend partiellement l'élément à vis (122) reliant l'équerre-support (114) à l'unité de construction électronique telle que support de câblage comme une carte de bus (24) ou un connecteur enfichable (26).

10. Dispositif selon au moins la revendication 9,
**caractérisé en ce**
**que** le retrait (134) est délimité par une section de profil s'étendant perpendiculairement au plan sous-tendu par le profil, laquelle section de profil délimite elle-même le deuxième profilage (96, 98, 100, 102) ou son côté s'étendant parallèlement au plan, du deuxième profilage formant en coupe la croix orthogonale.

11. Dispositif selon au moins une des revendications précédentes,
**caractérisé en ce**
**que** des évidements ouverts vers l'extérieur, tels que des trous oblongs (152, 154), partent de la surface s'étendant côté extérieur du boîtier, du profil formant la paroi inférieure et la paroi supérieure (12, 14), dans lesquels s'engagent des éléments de fixation au moyen desquels les parois latérales (20, 22) sont reliées à la paroi supérieure ou à la paroi inférieure (12, 14).

12. Dispositif selon au moins une des revendications précédentes,
**caractérisé en ce**
**que** les éléments de positionnement (86, 112, 114, 142, 144, 146) sont conçus sous forme de barre perforée ou de barre filetée et se composent de préférence d'acier, notamment d'acier galvanisé ou d'acier inoxydable.

13. Dispositif selon au moins une des revendications précédentes,
**caractérisé en ce**
**que** les parois inférieure, supérieure, avant, arrière et latérales (12, 14, 16, 18, 20, 22) forment un boîtier entièrement fermé avec traversée de câble étanche et sont étanchéifiées les unes par rapport aux autres par le biais de joints (28, 30, 32, 34, 36, 38) au moyen desquels l'intérieur du boîtier est au moins protégé des jets d'eau.

14. Dispositif selon au moins la revendication 13,
**caractérisé en ce**
**que** les joints sont des joints plats (28, 30, 32, 34, 36, 38) constitués notamment de silicone et de préférence de fluorosilicone et contenant, le cas échéant, des particules électriquement conductrices par exemple en aluminium argenté ou en graphite galvanisé.
